# EUROPEAN PATENT APPLICATION

(11) **EP 4 053 966 A1**
(43) Date of publication of application: **07.09.2022**
(21) Application number: 20882018.3
(22) Date of filing: 03.09.2020
(51) Int. Cl.: H01M 10/48, H02J 7/00

(54) **ELECTRIC STORAGE SYSTEM AND MANAGEMENT METHOD**

(30) Priority: 29.10.2019 JP 2019196481
(71) Applicant: Kyocera Corporation, Kyoto-shi Kyoto 612-8501 (JP)
(72) Inventor: FUKUDA, Tatsuya, Kyoto-shi, Kyoto 612-8501 (JP); TAKENAKA, Tetsuya, Kyoto-shi, Kyoto 612-8501 (JP)
(74) Representative: TBK
(86) International application number: PCT/JP2020/033388
(87) International publication number: WO 2021/084901

(57) **Abstract**

A first power storage device, a second power storage device, and a third power storage device start discharging, with all of the three power storage devices in a state of full charge (TH1). The discharging continues until the second power storage device and the third power storage device can secure a residual capacity Pa, which is equal to or greater than a minimum residual capacity P. Then, the second power storage device and the third power storage device are disconnected, and the first power storage device is discharged to a capacity TH2. After the end of the operation described above, the total capacity of the first power storage device is measured by calculating TH1 - TH2.

## Description

### Technical Field

The present disclosure relates to a power storage system and a management method thereof.

### Background Art

A power storage system including two or more power storage devices connected in parallel with respect to one power conversion device (power conditioning system; PCS) is known. In such a power storage system, the capacities of the power storage devices may be measured in a maintenance mode (capacity measurement mode) that is provided separately from a normal operating state (see Patent Document 1).

### Citation List

### Patent Literature

Patent Document 1: JP 2019-158397 A

### Summary

### Technical Problem

An aspect of the present disclosure is a power storage system including n (n is 2 or more) power storage devices connected in parallel with respect to one power conversion device and having a lower limit state of charge, which specifies a minimum residual capacity P to be secured for emergency, set for the n power storage devices as a whole. The power storage system includes a controller having a maintenance mode for measuring the capacity of each of the power storage devices. In the maintenance mode, the controller is configured to start discharging, with each of the n power storage devices fully charged, to secure a residual capacity Pa as a residual capacity of (n-1) power storage devices other than a target power storage device whose capacity is to be measured, the residual capacity Pa being equal to or greater than the minimum residual capacity P. In such a state, the controller is configured to disconnect the power storage devices other than the target power storage device, to finish discharging of the target power storage device, and to measure the capacity of the target power storage device.

Another aspect of the present disclosure is a management method used in a power storage system including n (n is 2 or more) power storage devices connected in parallel with respect to one power conversion device and having a lower limit state of charge, which specifies a minimum residual capacity P to be secured for emergency, set for the n power storage devices as a whole. The management method includes, in a maintenance mode for measuring a capacity of each of the power storage devices, the steps of: starting discharging, with each of the n power storage devices fully charged; securing a residual capacity Pa, which is equal to or greater than the minimum residual capacity P, as a residual capacity for (n-1) power storage devices other than a target power storage device whose capacity is to be measured; disconnecting the power storage devices other than the target power storage device; finishing discharging of the target power storage device; and measuring the capacity of the target power storage device.

### Brief Description of Drawings

FIG. 1 is a diagram illustrating a power storage system according to an embodiment.
FIG. 2 is a diagram for illustrating the capacity of a power storage device according to an embodiment.
FIG. 3 is a diagram for explaining charging and discharging of two or more power storage devices according to an embodiment.
FIG. 4 is a schematic view illustrating a change in the capacities of three power storage devices.
FIG. 5 is a schematic view illustrating a change in the capacities of three power storage devices.
FIG. 6 is a flowchart illustrating operations of a controller for two power storage devices.
FIG. 7 is a flowchart illustrating operations of a controller for two power storage devices.

### Description of Embodiments

Embodiments will be described below with reference to the drawings. Note that in the following description of the drawings, the same or similar components will be denoted by the same or similar reference signs. However, the drawings are schematic.

### Power Storage System

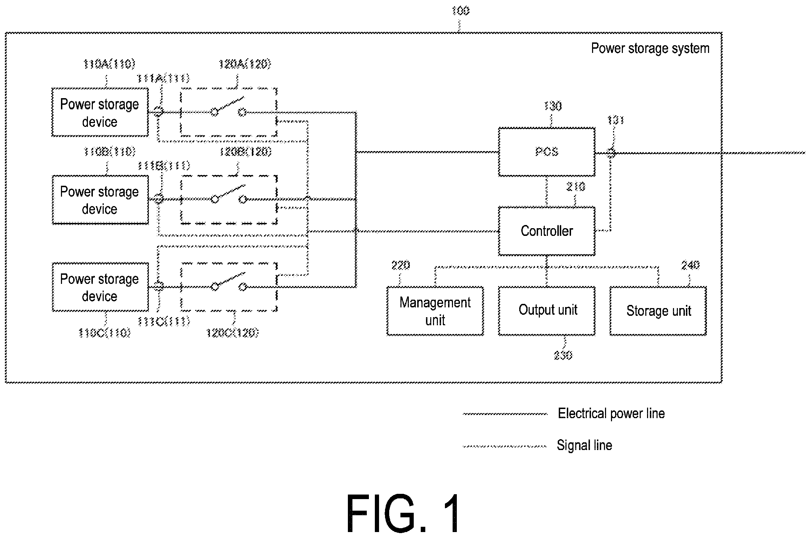

A power storage system according to an embodiment will be described below with reference to FIG. 1. As illustrated in FIG. 1, a power storage system 100 includes two or more power storage devices 110, two or more sensors 111, two or more switching units 120, a power conditioning system (PCS) 130, a sensor 131, a controller 210, a management unit 220, an output unit 230, and a storage unit 240.

The power storage device 110 is a device for storing electrical power. Specifically, the power storage device 110 includes two or more power storage cells that accumulate electrical power. The two or more power storage cells constitute a cell string connected in series with each other. The power storage device 110 may include two or more cell strings connected in parallel to each other. The power storage device 110 includes a discharge resistance connected to each of the two or more power storage cells, and may have a function (hereinafter, a cell balance function) that suppresses variations in the voltage values of the two or more power storage cells by discharging from the power storage cell to the discharge resistance. The voltage values of the power storage cells are equalized by repeating charging or discharging of the power storage device 110.

In FIG. 1, the power storage device 110 is exemplified by power storage devices 110A to 110C. Two or more power storage devices 110 are connected in parallel with respect to one PCS 130.

The sensor 111 is provided on an output end of the power storage device 110, and detects the state of the power storage device 110. The state of the power storage device 110 includes a voltage value of the output end of the power storage device 110. The state of the power storage device 110 may include a current value of the electrical power discharged from the power storage device 110, and may include a current value of the electrical power to be charged to the power storage device 110.

Here, the term "output end" means an output end of electrical power during discharging of the power storage device 110. Accordingly, the "output end" is synonymous with the input end of electrical power during charging of the power storage device 110. In the following, for the sake of convenience of explanation, the side where electrical power is output during discharging of the power storage device 110 is referred to as the "output end", and the side where electrical power is input is referred to as the "input end".

In FIG. 1, the sensor 111 is exemplified by sensors 111A to 111C. The sensor 111A detects the state of the power storage device 110A. Similarly, the sensor 111B detects the state of the power storage device 110B, and the sensor 111C detects the state of the power storage device 110C.

The switching unit 120 switches electrical connection between the power storage device 110 and the PCS 130. Specifically, the switching unit 120 switches between connection and disconnection of an electrical power line connecting the power storage device 110 and the PCS 130. Hereinafter, the state in which the power storage device 110 and the PCS 130 are electrically connected is referred to as "ON", and the state in which the power storage device 110 and the PCS 130 are electrically disconnected is referred to as "OFF". The switching unit 120 may be a mechanical relay mechanism, although not particularly limited thereto. The switching unit 120 may be a relay circuit configured by a switching element.

In FIG. 1, the switching unit 120 is exemplified by switching units 120A to 120C. The switching unit 120A switches the ON/OFF of the power storage device 110A. Similarly, the switching unit 120B switches the ON/OFF of the power storage device 110B, and the switching unit 120C switches the ON/OFF of the power storage device 110C.

The PCS 130 is a power conversion device configured to convert direct current power discharged from the power storage device 110 to alternating current power and converts direct current power charged to the power storage device 110 to alternating current power. The input end of the PCS 130 is connected to the power storage device 110 via the electrical power line. The output end of the PCS 130 is connected to the electrical power system via the electrical power line. The output end of the PCS 130 may be connected to a device (such as another distributed power supply or load) provided in a facility including the power storage system 100 via an electrical power line. Here, the PCS 130 may have a terminal (self-supporting terminal) that connects the device provided in the facility with the PCS 130, while the power storage system 100 is disconnected from the electrical power system (hereinafter, a self-supporting operation state).

The sensor 131 is provided at the output end of the PCS 130 and detects the state of the PCS 130. The state of the PCS 130 includes a voltage value of the output end of the PCS 130. The state of the PCS 130 may include a current value of electrical power output from the PCS 130 during discharging of the power storage device 110, and may include a current value of electrical power input to the PCS 130 during charging of the power storage device 110.

The controller 210 may include at least one processor. The at least one processor may be configured of a single integrated circuit (IC) or of a plurality of circuits (such as integrated circuits and/or discrete circuits) that are communicably connected with each other.

The controller 210 is connected to a configuration provided in the power storage system 100 via a signal line. Here, the controller 210 is connected to the sensor 111, the PCS 130, and the sensor 131 via the signal line. The controller 210 controls charging or discharging of the power storage device 110 by control of the PCS 130. The controller 210 obtains the state of the power storage device 110 from the sensor 111. The controller 210 obtains the state of the PCS 130 from the sensor 131.

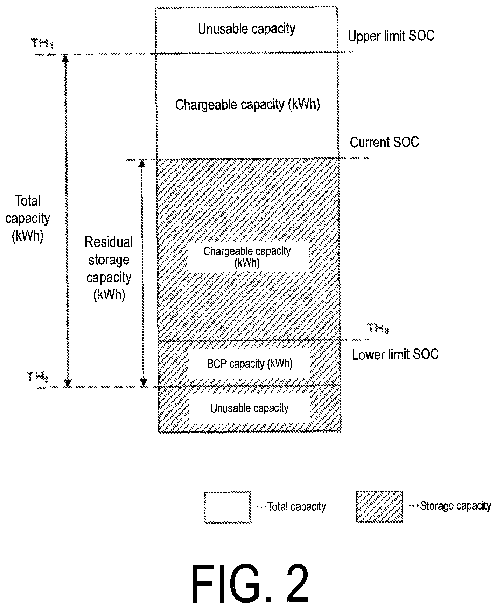

The management unit 220 manages information regarding the power storage system 100. The management unit 220 includes, for example, a memory such as a non-volatile memory and/or a storage medium such as a hard disc drive (HDD). Specifically, the management unit 220 manages information identifying two or more individual states of charge (hereinafter, individual SOC) each corresponding to each of the two or more power storage devices 110. The management unit 220 manages information identifying the total state of charge (hereinafter, the total SOC) of the power storage system 100. The details of the SOC will be described later (see FIG. 2).

The output unit 230 outputs information managed by the management unit 220. Specifically, the output unit 230 outputs information identifying the total SOC. The output unit 230 may output information identifying the individual SOC. The form of output may be a display or sound, although not particularly limited thereto. For example, the output unit 230 may be configured by a display or by a speaker. Alternatively, the output unit 230 may be configured by a communication module, and may transmit information managed by the management unit 220 to an external device. The communication module may be a wireless communication module compliant with standards such as IEEE 802.11a/b/g/n, ZigBee, Wi-SUN, and LTE, or may be a wired communication module compliant with standards such as IEEE 802.3. The external device may be a user terminal such as a personal computer or a smart phone, and may be an energy management system (EMS) provided in a facility including the power storage system 100.

The storage unit 240 stores information managed by the management unit 220 as a log. The storage unit 240 includes a memory such as a memory such as a non-volatile memory and/or a storage medium such as an HDD. The storage unit 240 stores a change in the total SOC as a log. The storage unit 240 may store a change in the individual SOC as a log. The storage unit 240 may store a change in the operation state (e.g., charging, discharging, and waiting) of the PCS 130 as a log.

### Capacity of Power Storage Device

The capacity of the power storage device 110 according to an embodiment will be described below with reference to FIG. 2.

As illustrated in FIG. 2, the capacity of the power storage device 110 includes an unusable capacity, the use of which by the power storage device 110 is limited for the purpose of suppression of degradation of the power storage device 110 and the like. A threshold value TH1 is a threshold value identifying the unusable capacity (upper limit side), and a threshold TH2 is a threshold value identifying the unusable capacity (lower limit side). The capacity of the power storage device 110 includes an emergency capacity or a business continuity plan (BCP) capacity for an emergency situation such as a disaster. A threshold TH3 is a threshold identifying the BCP capacity.

The following explanation assumes that the total capacity of the power storage device 110 is a capacity excluding the unusable capacity. In a normal state other than an emergency situation, the BCP capacity is not used, and the capacity (dischargeable capacity) that can be discharged from the power storage device 110 is a value excluding the BCP capacity from the electrical power stored in the power storage device 110 (residual storage capacity). The capacity that can be charged to the power storage device 110 (chargeable capacity) is a value excluding the residual storage capacity from the total capacity. Note that the sum of the residual storage capacity and the unusable capacity (lower limit side) is referred to as the storage capacity for convenience.

The SOC of the power storage device 110 may be defined with the capacity between the TH1 and the TH2 (i.e., the total capacity of the power storage device 110) as a reference. Specifically, the SOC of the power storage device 110 is represented by the ratio of the storage capacity of the power storage device 110 to the total capacity of the power storage device 110. An upper limit SOC is identified by the threshold TH1 described above. A lower limit SOC is identified by the threshold TH3.

In such a case, the SOC may be measured by a method using a curve (hereinafter, an SOC-OCV curve) that represents the relationship between the SOC and an open circuit voltage (OCV). In such a method, the SOC can be measured by detecting the voltage value of the output end of the power storage device 110. However, the method of measuring the SOC is not limited thereto, and may be a method using integration of current that accompanies charging or discharging of the power storage device 110.

Furthermore, the total capacity is remeasured by periodic maintenance of the power storage device 110. Specifically, a re-measurement is performed by discharge of the power storage device 110 from a full charged state to a predetermined discharged state. A predetermined discharged state is a state in which the BCP capacity has been discharged. On the other hand, the discharging does not include that of the unusable capacity (lower limit side). In measuring the SOC using the SOC-OCV curve, such a maintenance redefines voltage values corresponding to the upper limit SOC and the lower limit SOC. A more detailed operation during maintenance will be described later.

While FIG. 2 describes the capacity and SOC of one power storage device 110, the same applies to the capacities and SOCs of two or more power storage devices 110 connected in parallel with each other. Therefore, details thereof are omitted.

### Charging and Discharging

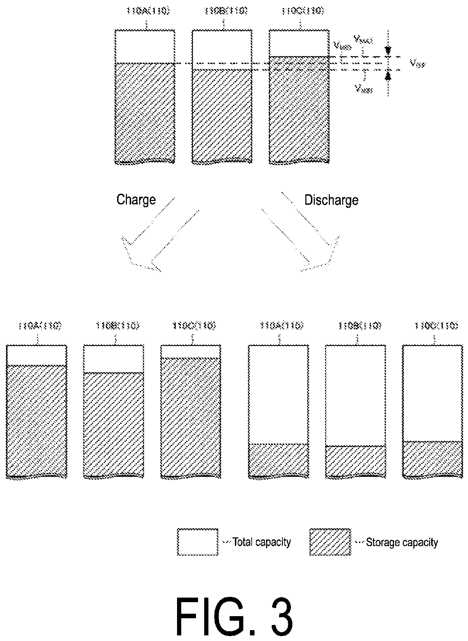

Charging and discharging of two or more power storage devices 110 according to an embodiment will be described below with reference to FIG. 3. In an explanation here, all of the power storage devices 110A to 110C are assumed to be ON.

FIG. 3 exemplifies a case in which the voltage value corresponding to the amount of the residual storage capacity of the power storage device 110C is a maximum voltage value (VMAX); the voltage value corresponding to the residual storage capacity of the power storage device 110B is a minimum voltage value (VMIN); and the voltage value corresponding to the residual storage capacity of the power storage device 110A is an intermediate voltage value (VMID) between the VMAX and the VMIN.

In such a case, the two or more power storage devices 110 are charged and discharged to suppress degradation of the power storage devices 110 generated by a horizontal flow of the two or more power storage devices 110, in a state in which the difference (VDIF) between the VMAX and the VMIN is a threshold value (THDIF).

As illustrated in FIG. 3, a variation in the voltages of the power storage devices 110 (VDIF described above) may be reduced by charging or discharging the two or more power storage devices 110. However, the VDIF can expand due to a variation of the internal resistances of the power storage devices 110. Furthermore, the VDIF may expand due to natural discharging or the like after a lapse of time without charging or discharging of the power storage devices 110.

### Management During Management

As described above, the power storage system 100 according to the present embodiment includes n power storage devices 110 (n is 2 or more) connected in parallel with respect to one power conversion device (PCS 130), the n power storage devices 110 as a whole having the lower limit state of charge set therefor, which specifies a minimum residual capacity P (total BCP capacity) to be secured for emergency.

In the power storage system 100, the controller 210 has a maintenance mode for measuring the capacity of each of the power storage devices 110. In the maintenance mode, the controller 210 starts discharging with each of the n power storage devices 110 fully charged, and secures a residual capacity Pa, which is equal to or greater than the minimum residual capacity P (kWh), as the residual capacity of (n-1) power storage devices 110 other than the target power storage device whose capacity is to be measured. In this state, the controller 210 disconnects the power storage devices 110 other than the target power storage device, finishes discharging of the target power storage device, and measures the capacity of the target power storage device. Thus, the power storage system 100 of the present embodiment secures the minimum residual capacity P as the residual capacity of the n power storage devices 110 in the normal operating state, which is different from the maintenance mode, whereas in the maintenance mode, the same secures the residual capacity Pa, which is equal to or greater than the minimum residual capacity P, as the residual capacity of the (n-1) power storage devices 110 other than the target power storage device.

Further, the controller 210 charges the target power storage device, whose capacity has been measured, until the residual capacity of the target power storage device reaches Pa/(n-1), and then executes a process in which: the target power storage device is disconnected; of the power storage devices 110 whose capacities have not been measured, a second target power storage device whose capacity is to be measured is connected; the discharging of the second target power storage device is completed; and the capacity of the second target power storage device is measured. Thereafter, the second target power storage device is charged to Pa/(n-1).

Note that the residual capacity of each of the power storage devices 110 can be obtained by measuring the voltage of each of the power storage devices 110 and calculating in accordance with the voltage value obtained and the voltage values corresponding to the upper limit SOC and the lower limit SOC.

The controller 210 may stop the process of measuring the capacities of the power storage devices 110 when time that has elapsed after the start of the maintenance mode exceeds time that can be allowed to run the maintenance mode.

The controller 210 may also stop the process of measuring the capacity of a power storage device 110 when the temperature of the power storage device 110 is less than a predetermined temperature. Specifically, a temperature sensor is installed on each of the power storage devices 110, and temperatures obtained by the temperature sensors are input to the controller 210. When there is a power storage device 110 at a temperature below a predetermined temperature, the controller 210 stops the process of measuring the capacity of the power storage device 110.

When there is a power storage device 110 whose capacity has not been measured during the execution of the previous maintenance mode, the controller 210 may preferentially execute the measurement of the capacity of the power storage device 110 during the execution of the next maintenance mode. Here, the "case in which there is a power storage device 110 whose capacity has not been measured during the execution of the previous maintenance mode" includes a case in which the measurement of the capacity of the power storage device 110 has stopped during the previous maintenance mode due to the operation described above. In this case, the process for measuring the capacities of all the power storage devices 110 has temporarily stopped during the previous maintenance mode, and resumes in the next maintenance mode after the normal operation state.

The controller 210 completes the maintenance mode, and then connects the n power storage devices 110 in parallel with the residual capacities thereof all at Pa/(n-1).

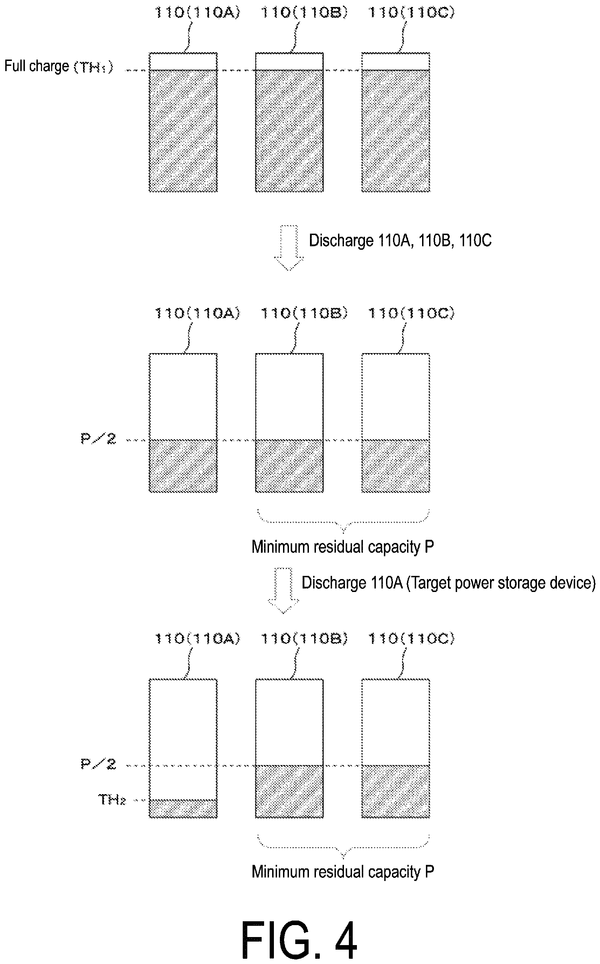

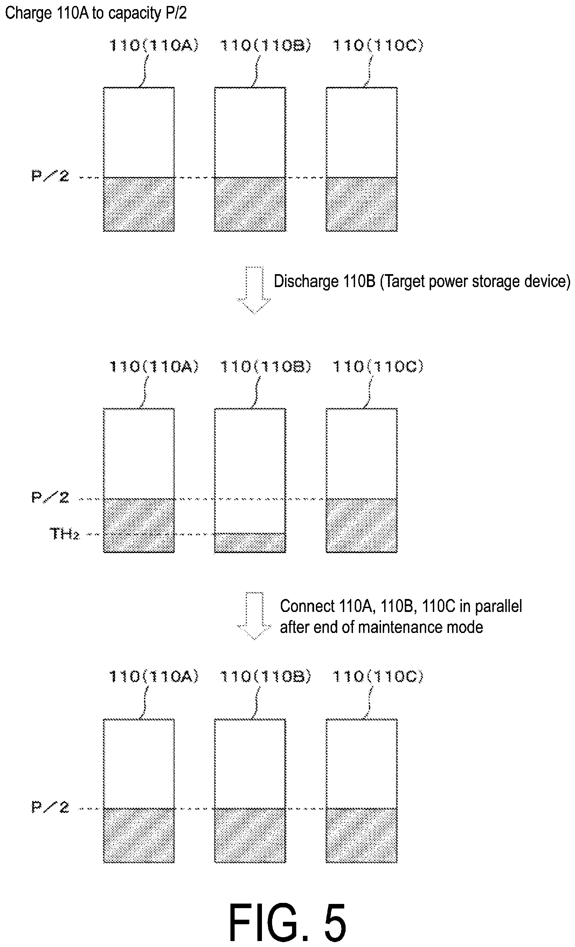

FIGS. 4 and 5 are each a schematic view illustrating a change in the capacities of the power storage devices 110 when n = 3. FIGS. 4 and 5 each exemplifies a case in which the residual capacity Pa described above is the minimum residual capacity P. As illustrated in FIG. 4, discharging of the power storage device 110A, the power storage device 110B, and the power storage device 110C starts with the three power storage devices 110A to 110C fully charged (TH1), and the discharging continues until the power storage device 110B and the power storage device 110C can together secure the minimum residual capacity P. The capacity of the power storage device 110 then is P/(n-1) = P/2. Then, the switching unit 120B and the switching unit 120C, which are illustrated in FIG. 1, disconnect (turn "OFF") the power storage device 110B and the power storage device 110C, respectively, and then discharge the power storage device 110A to the capacity TH2. After the end of the operation described above, the total capacity of the power storage device 110A is measured by calculating TH1 - TH2.

Next, as illustrated in FIG. 5, the power storage device 110A is charged to the capacity P/2. Thereafter, the switching unit 120A illustrated in FIG. 1 disconnects the power storage device 110A, the switching unit 120B connects (turns "ON") the power storage device 110B, and the power storage device 110 which is the second target power storage device is discharged to the capacity TH2. After the end of the operation described above, the total capacity of the power storage device 110B is measured by calculating TH1 - TH2. The power storage device 110B is charged to the capacity P/2, and then the power storage device 110C is subjected to the same operation as the power storage device 110B to measure the total capacity thereof, and then is charged to the capacity P/2.

### Management Method

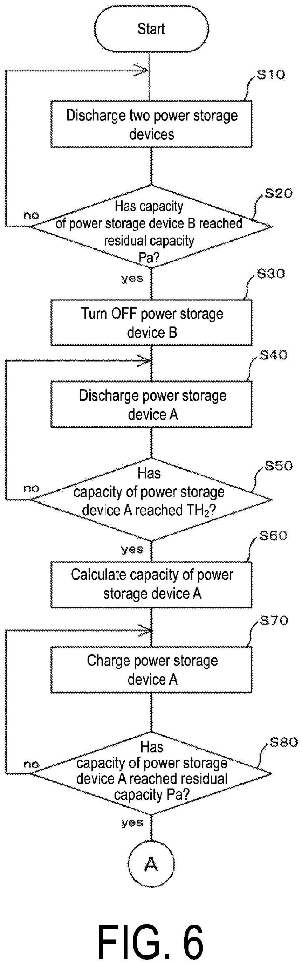

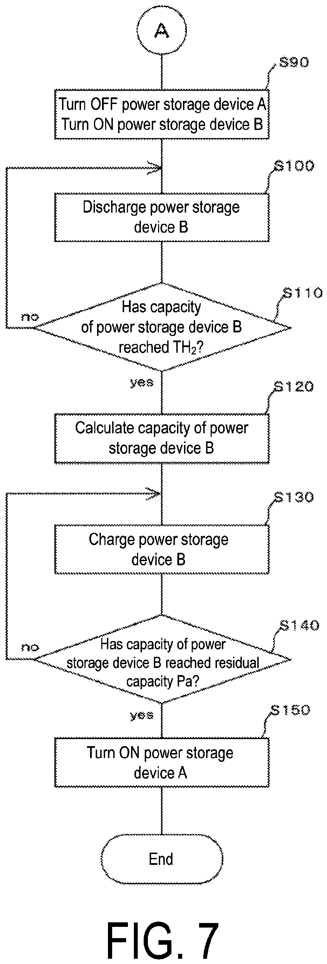

A management method according to an embodiment will be described below with reference to FIG. 6 and FIG. 7. FIG. 6 and FIG. 7 explains the operation of the controller 210 for two power storage devices (the power storage device A and the power storage device B).

When the maintenance mode starts, the power storage device A and the power storage device B, which are at full charge (capacity TH1), are discharged (S10).

Then, it is determined whether the capacity of the power storage device B has reached the residual capacity Pa by the discharging (S20). When the capacity of the power storage device B has not reached the residual capacity Pa (no in S20), the discharging is continued. When the capacity of the power storage device B has reached the residual capacity Pa (yes in S20), the power storage device B is turned to OFF using a switching unit such as a relay (S30).

Then, the power storage device A is discharged (S40). Next, it is determined whether the capacity of the power storage device A has reached the TH2 by the discharging (S50). When the capacity of the power storage device A has not reached the TH2 (no in S50), the discharging is continued. When the capacity of the power storage device A has reached the TH2 (yes in S50), the capacity of the power storage device A is measured (S60).

Then, the power storage device A starts being charged (S70), and it is determined whether the capacity of the power storage device A has reached the residual capacity Pa (S80). When the capacity of the power storage device A has not reached the residual capacity Pa (no in S80), the discharging is continued. When the capacity of the power storage device A has reached the residual capacity Pa (yes in S80), the power storage device A is turned OFF using a switching unit such as a relay, and the power storage device B is turned ON (S90).

Then, the power storage device B is discharged, with the residual capacity Pa secured by the power storage device A (S100). Next, it is determined whether the capacity of the power storage device B has reached the TH2 by the discharging (S110). When the capacity of the power storage device B has not reached the TH2 (no in S110), the discharging is continued. When the capacity of the power storage device B has reached the TH2 (yes in S110), the capacity of the power storage device B is measured (S120).

Then, the power storage device B starts being charged (S130), and it is determined whether the capacity of the power storage device B has reached the residual capacity Pa (S140). When the capacity of the power storage device B has not reached the residual capacity Pa (no in S140), the discharging is continued. When the capacity of the power storage device B has reached the residual capacity Pa (yes in S140), the power storage device A is turned ON using a switching unit such as a relay (S150).

### Actions and Effects

The power storage system 100 described above secures, in the maintenance mode, the residual capacity Pa, which is equal to or larger than the minimum residual capacity P, by the power storage devices other than the target power storage device whose capacity is to be measured, and then reduces the capacity of the target power storage device. Thus, the power storage system 100 can measure the capacity of the target power storage device while securing the minimum residual capacity P, and can cope with power supply in an emergency and the like.

Further, after the end of the maintenance mode, by connecting the n power storage devices in parallel with the residual capacities thereof all at Pa/(n-1), it is possible to shift to the normal operating state immediately after the end of the maintenance mode with the minimum residual capacity P secured.

When time lapsed during the maintenance mode does not satisfy the predetermined condition, the process of measuring the capacities of the power storage devices can be stopped to ensure the transition to the normal operating state after a predetermined time elapses. When the temperature of a power storage device in the maintenance mode does not satisfy a predetermined condition, the process of measuring the capacity of the power storage device can be stopped to more accurately measure the capacities of the power storage devices. In this case, by preferentially measuring the capacity of the power storage device in a next maintenance mode whose measurement has been stopped in the previous maintenance mode, no power storage device is left unmeasured for its capacity and the capacities of the power storage devices each can be accurately determined.

### Other Embodiments

Although the present disclosure has been described by the above-described embodiments, it should be understood that the description and the drawings which form a part of this disclosure do not limit this disclosure. Various alternative embodiments, examples, and operational techniques will be apparent from this disclosure to those skilled in the art.

Although not particularly described in the embodiments, at least one of the controller 210, the management unit 220, the output unit 230, and the storage unit 240 may be a PCS 130, and may be provided in an EMS provided in a facility including the power storage system 100. The EMS may be provided by a cloud service.

Although not particularly described in the embodiments, the signal line provided in the power storage system 100 may be wired or wireless.

Although not particularly described in the embodiments, the controller 210 may control charging or discharging of the power storage system 100 in accordance with the total SOC managed by the management unit 220. For example, the controller 210 may stop charging the power storage system 100 when the total SOC has reached the upper limit SOC. Similarly, the controller 210 may stop discharging the power storage system 100 when the total SOC has reached the lower limit SOC.

A condition to stop the process of measuring the capacities of the power storage devices may be that the current time during the execution of the maintenance mode has reached a predetermined time (for example, 6:00 AM or sunrise time).

Note that all of the contents of Japanese Patent Application No. 2019-196481 (filed on October 29, 2019) are incorporated in the present specification by reference.

## Claims

1. A power storage system comprising:
n (n is 2 or more) power storage devices connected in parallel with respect to one power conversion device, the n power storage devices as a whole having set therefor a lower limit state of charge, which specifies a minimum residual capacity P to be secured for emergency; and
a controller having a maintenance mode for measuring a capacity of each of the power storage devices,
the controller being configured, in the maintenance mode, to start discharging, with the n power storage devices fully charged, to secure a residual capacity Pa, which is equal to or greater than the minimum residual capacity P, as a residual capacity of (n-1) power storage devices other than a target power storage device whose capacity is to be measured, then to disconnect the power storage devices other than the target power storage device, to finish discharging the target power storage device, and to measure the capacity of the target power storage device.

2. The power storage system according to claim 1, wherein the controller is configured to execute a process comprising steps of: charging the target power storage device whose capacity has already been measured until the residual capacity of the target power storage device reaches Pa/(n-1); then disconnecting the target power storage device; connecting a second target power storage device whose capacity is to be measured, the second target power storage device being one of power storage devices whose capacities are to be measured; finishing discharging of the second target power storage device; and measuring the capacity of the second target power storage device.

3. The power storage system according to claim 1 or 2, wherein the controller is configured to connect the n power storage devices in parallel after the maintenance mode is finished, with residual capacities thereof all at Pa/(n-1).

4. The power storage system according to any one of claims 1 to 3, wherein the controller is configured to stop a process of measuring the capacity of the power storage device when time lapsed after a start of the maintenance mode has exceeded time allowed for the maintenance mode to be executed.

5. The power storage system according to any one of claims 1 to 4, wherein the controller is configured to stop the process for measuring the capacity of the power storage device when a temperature of the power storage device is less than a predetermined temperature.

6. The power storage system according to claim 4 or 5, wherein the controller is configured to preferentially measure the capacity of the power storage device in a next maintenance mode when the capacity of the power storage device has not been measured in a previous maintenance mode.

7. A management method used for a power storage system comprising n (n is 2 and more) power storage devices connected in parallel with respect to one power conversion device, the n power storage devices as a whole having set therefor a lower limit state of charge, which specifies a minimum residual capacity P to be secured for emergency, the management method comprising, in a maintenance mode for measuring a capacity of each of the power storage devices, the steps of:
starting discharging with each of the n power storage devices fully charged;
securing a residual capacity Pa, which is equal to or greater than the minimum residual capacity P, as a residual capacity of (n-1) power storage devices other than a target power storage device whose capacity is to be measured;
disconnecting the power storage devices other than the target power storage device;
finishing discharging of the target power storage device; and
measuring the capacity of the target power storage device.
